# EUROPÄISCHE PATENTSCHRIFT

(11) **EP 2 486 587 B1**
(45) Veröffentlichungstag und Bekanntmachung des Hinweises auf die Patenterteilung: **27.08.2014**
(21) Anmeldenummer: 10776927.5
(22) Anmeldetag: 18.09.2010
(51) Int. Cl.: H01H 23/10, H01L 23/10, G01S 7/03

(54) **HERMETISCHES DICHTES HOCHFREQUENZ-FRONTEND**
HERMETICALLY SEALED RADIO-FREQUENCY FRONT END
FRONTAL HAUTE FRÉQUENCE HERMÉTIQUE ÉTANCHE

(30) Priorität: 09.10.2009 DE 102009048838
(43) Veröffentlichungstag der Anmeldung: 15.08.2012
(73) Patentinhaber: Airbus Defence and Space GmbH, 85521 Ottobrunn (DE)
(72) Erfinder: FELDLE, Heinz-Peter, 89250 Senden (DE); SCHÖNLINNER, Bernhardt, 81547 München (DE); PRECHTEL, Ulrich, 81739 München (DE); SANDER, Jörg, 89075 Ulm (DE)
(74) Vertreter: Riegel, Werner
(86) Internationale Anmeldenummer: PCT/DE2010/001105
(87) Internationale Veröffentlichungsnummer: WO 2011/042000

(56) Entgegenhaltungen:
- EP-A1- 1 328 042
- WO-A1-81/00949
- US-A- 3 403 300
- US-A- 5 311 402
- US-A1- 2003 062 533
- US-B1- 6 218 730

## Beschreibung

Die Erfindung betrifft ein Hochfrequenz(HF)- Frontend in einer Mehrlagenstruktur gemäß den Merkmalen des Patentanspruchs 1. Dieses HF-Frontend ist für die Anwendung als Sende-/Empfangsmodul, Sendemodul oder Empfangsmodul ausgelegt.

Die Erfindung ist u. a. anwendbar in aktiven Antennen (active electronically steerable antenna AESA) in Radarsystemen, SAR (synthetic apertur radar), Systeme der elektronischen Krieg- oder Einsatzführung (electronic warfare EW) sowie für Navigations- und Kommunikationssysteme. Mögliche Plattformen sind Boden- und Marine-Systeme, Flugzeuge, Satelliten, Drohnen und Flugkörper sowie gebäude- oder fahrzeug-gebundene Systeme. Die Mehrlagenstruktur dieser Module ist die Voraussetzung für eine hohe Miniaturisierung der Module sowie deren Anordnung in konformen und/oder strukturintegrierten Antennengruppen (antenna arrays).

Aus EP 1 328 042 B1 ist ein Sende-/Empfangsmodul für ein Radarsystem bekannt, welches aus mehreren aufeinander gestapelten Substratschichten (layern) besteht, welche mit Lötkugeln (solder bumps) verbunden sind. Wegen der endlichen Ausdehnung der Lötkugeln verbleiben Spalte zwischen benachbarten Substratschichten. Durch diese Spalte können Feuchtigkeit und andere Verschmutzungen in das Modulinneren eindringen, die die elektrische Funktion der einzelnen Komponenten, z.B. elektrische Bauteile, innerhalb des Moduls beeinflussen oder gegebenenfalls bis zum Totalausfall schädigen. Trotz der in EP 1 328 042 B1 beschriebenen Lötverbindung zwischen den einzelnen Schichten ist keine hermetische Dichtigkeit des Modulinneren gewährleistet. Diese hermetische Dichtigkeit ist jedoch die Voraussetzung für den Einsatz dieser Module für Raumfahrtanwendungen und Plattformen in kritischen Umweltbedingungen.

WO81/00949 beschreibt eine Halbleiterbauelementpackung umfassend einen Chip-Träger, wobei der Chip-Träger aus einer Vielzahl von Schichten aus isolierendem Material aufgebaut ist. Diese Schichten weisen an ihren Rändern metallisierte Rillen auf, wodurch ein elektrischer Kontakt benachbarter Schichten hergestellt werden kann.

Aus US 5,311,402 ist im Wesentlichen eine Halbleiteranordnung bekannt, bei welcher eine integrierte Schaltung auf einer Leiterplatte befestigt ist und ein Deckel zur hermetischen Abdeckung vorgesehen ist.

Aus US 3,403,300 ist ein Stapel aus Leiterplatten bekannt.

Ein Schutz vor Umwelteinflüssen ist durch äußere Maßnahmen möglich, z.B. zusätzliche verschweißte Schutzhüllen, durch welche die Querschnittsabmessungen der Sende-/Empfangsmodule vergrößert werden. Zudem wirken mechanischen Kräfte durch die Verformung solcher Schutzhüllen beim Verschweißen auf die Mehrlagenstruktur, die die Langzeitstabilität der Module beeinflusst oder die Lötverbindungen zwischen den Modullagen unterbrechen können. Zudem ermöglichen solche Schutzhüllen, z. B aus Kunststoff (z. B. Polymere) nur einen eingeschränkten, jedoch keine hermetische Dichtigkeit. Weiterhin können solche Kunststoffe über die Zeit ausgasen und somit die Bauelemente und deren Verbindungen zu den Substraten schädigen.

Aufgabe der Erfindung ist es, ein gattungsgemäßes HF-Frontend (z. B. Sende-/Empfangsmodul mit integriertem Strahlerelement) mit einem hermetisch dichtem Innenraum anzugeben.

Diese Aufgabe wird mit dem HF-Frontend gemäß den Merkmalen des Anspruchs 1 gelöst. Vorteilhafte Ausführungen der Erfindung sind Gegenstand von Unteransprüchen.

Das erfindungsgemäße HF-Frontend ist in Mehrlagenstruktur ausgeführt und umfasst elektronische Bauelemente, wobei die Mehrlagenstruktur mehrere übereinander gestapelte, die Bauelemente tragende Substrate enthält. Das Modul zeichnet sich dadurch aus, dass in den Substraten Nuten (an den Randbereichen der jeweiligen Lagenstruktur) ausgeführt sind und zwischen den Substraten Dichtelemente (z. B. metallische Rahmen oder Deckel) zwecks hermetischer Abdichtung vorhanden sind, welche in die Nuten eingesetzt sind, wobei die Dichtelemente in Nuten benachbarter Substrate eingreifen. Erfindungsgemäß sind benachbarte Substrate miteinander verlötet.

In einer ersten Ausführungsform der Erfindung ist das Dichtelement ein offenes Rahmenelement, welches in die Nuten zweier benachbarter Strukturen eingreift. In einer zweiten Ausführungsform der Erfindung ist das Dichtelement ein geschlossenes Deckelelement, das eine hermetischer Dichtigkeit jedes einzelnen Substrates (Modul-Layer) sicherstellt.

Die Erfindung wird im Weiteren anhand von Figuren näher erläutert. Es zeigen
- Fig. 1a: eine schematisierte seitliche Ansicht eines erfindungsgemäßen HF-Frontends in der ersten Ausführungsform mit einer im Innenbereich verlaufenden Nut,
- Fig. 1b: eine vergrößerte Darstellung der Nut aus dem Bereich A in Fig. 1 a,
- Fig. 1c: eine schematisierte Darstellung eines erfindungsgemäßen Rahmenelements der ersten Ausführungsform,
- Fig. 2: eine schematisierte Darstellung eines erfindungsgemäßen HF-Frontends in der ersten Ausführungsform mit einer im Außenbereich verlaufenden Nut,
- Fig. 3: eine schematisierte seitliche Ansicht eines erfindungsgemäßen HF-Frontends in der zweiten Ausführungsform.

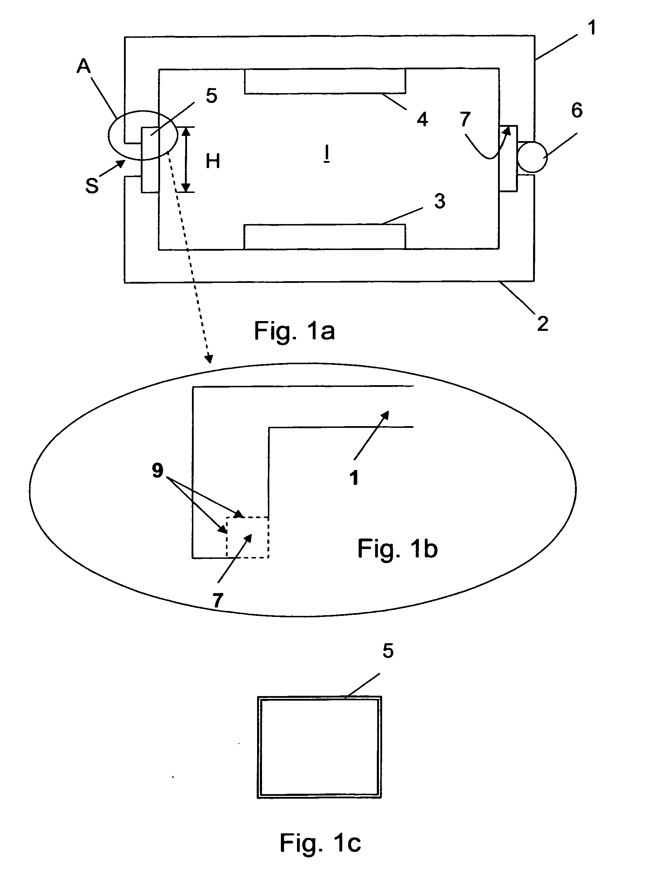

In der Fig. 1a ist eine erste Ausführungsform eines erfindungsgemäßen HF-Frontends (z. B. Sende-/Empfangsmodul) dargestellt. Es zeigt zwei übereinander gestapelte Substrate 1, 2, welche jeweils (mindestens) ein Bauelement 3, 4, z.B. Verstärker, Phasenschieber, Amplitudensteller, Sende-Empfangsweiche (Zirkulator), Steuerelektronik (z. B. anwenderspezifische integrierte Schaltungen, ASIC oder FPGA) oder Antennenelement tragen. Jedes Substrat 1, 2 weist eine, zweckmäßig entlang des Umfangs eines Substrats verlaufende Nut 7. In diese Nut 7 ist ein (vorteilhafterweise metallisches oder aus Kunststoff mit äußerer Metallisierung) Rahmendichtelement 5 (Fig. 1 c) eingebracht. Dieses Rahmenelement 5 greift dabei in die Nuten 7 der beiden benachbarten Substrate 1, 2 ein. Das Rahmenelement 5 wird zweckmäßig in die Nuten gelötet oder geklebt (siehe Kontaktflächen 9 in Fig. 1b).

Die Höhe H des Rahmenelements 5 ist zweckmäßig so gewählt, dass zwischen den beiden Substraten 1, 2 ein Spalt S entsteht. Die Höhe H des Rahmenelements 5 ist der Größe des Spalts S angepaßt, der sich durch das Aufschmelzen der Lotkugeln zur elektrischen und thermischen Verbindung der benachbarten Substrate 1,2 ergibt. Eine elektrische Verbindung zwischen den Lotkugeln 6 und dem Rahmenelement 5 ist zu vermeiden, ansonsten könnte es zu einem elektrischen Kurzschluss und somit Ausfall des HF-Frontends führen.

Fig. 1b zeigt eine Anordnung mit dem an den Kontaktflächen 9 eingelöteten Rahmenelement 5 im Innenbereich zweier Modulsubstrate 1,2. Die Anordnung realisiert eine hermetische Dichtigkeit für den Innenbereich der benachbarten Modullagen 1,2. Fig. 1 a zeigt weiter, dass durch das verwendete Rahmenelement 5 ein offener Innenraum I zwischen den beiden Bauteilen 3, 4 der benachbarten Substrate 1, 2 gebildet wird. Die Lotkugeln 6 befinden sich im Außenbereich und sind somit vorteilhaft für elektrische Messungen zugänglich (z. B. nach der Fertigstellung der Module zur Prüfung der elektrischen Funktion der einzelnen Modullagen). Nachteilig ist für diese Anordnung die Möglichkeit von Verschmutzungen in diesem Verbindungsberich, der zur Beeinträchtigung der elektrischen Funktion oder Ausfall führen könnte. Dies kann durch entsprechende umwelttechnische Randbedingungen (z. B. Luftfilter) verhindert werden.

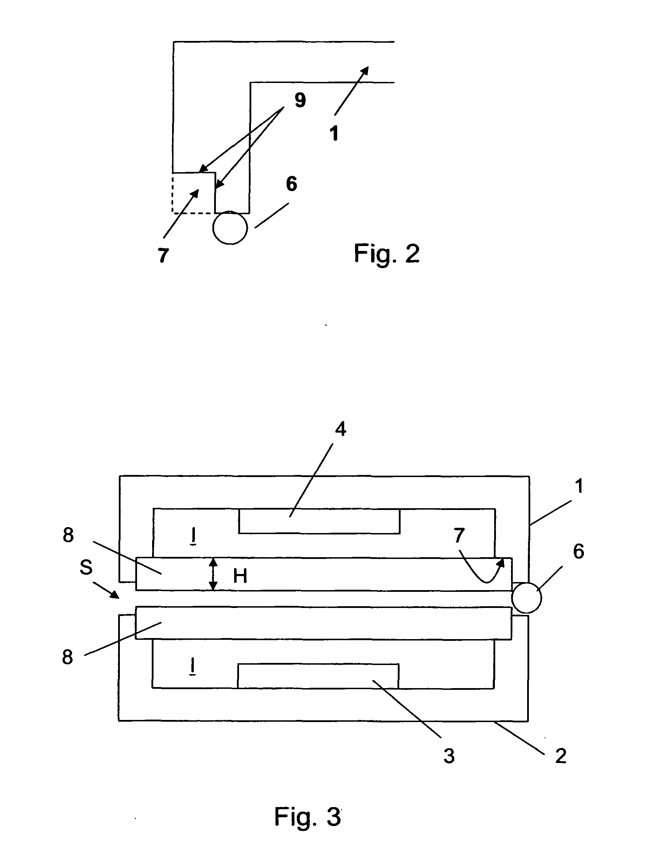

Fig. 2 zeigt einen Ausschnitt aus einem erfindungsgemäßen HF-Frontend entsprechend dem Bereich A in Fig. 1a, mit dem Unterschied, dass die Nut 7 im Außenbereich der Substrate 1, 2 verläuft, d.h. dem Innenbereich I abgewandt. An den dargestellte Kontaktflächen 9 wird dann das Rahmenelement 5 im Außenbereich zweier Modulsubstrate 1,2 eingelötet. Diese Anordnung realisiert eine hermetische Dichtigkeit für den Innenbereich I der benachbarten Substrate 1,2 (Modullagen). Die Lotkugeln 6 befinden sich im geschützten Innenbereich und sind somit nicht für nachträgliche elektrische Messungen zugänglich. Vorteilhaft ist der komplette Modulaufbau und die integrierten Komponenten, da eine vollständige hermetische Dichtigkeit realisiert wird. Zusätzliche umwelttechnsiche Randbedingungen sind nicht erforderlich.

In der Fig. 3 ist eine zweite Ausführungsform eines erfindungsgemäßen HF-Frontends dargestellt. Entsprechend Fig. 1 sind jeweils gleiche Bauteile mit gleichen Bezugszeichen bezeichnet. Die Ausführungsform in Fig. 3 unterscheidet sich von den in Fig. 1 und Fig. 2 gezeigten Ausführungsformen dadurch, dass kein offenes Rahmenelement verwendet wird, sondern ein geschlossenes Deckenelement 8 (z. B. metallischer Deckel).

Das Deckenelement 8 zeichnet sich im Wesentlichen dadurch aus, dass der jeweilige Innenraum eines Modulsubstrates für sich geschlossen und somit hermetisch dicht ist. Zudem wird der Innenraum I der benachbarten Substrate 1, 2 voneinander getrennt und somit die elektromagnetische Verkopplung der Bauelemente auf den verschiedenen Modulsubstraten vermieden. Die Deckenelemente 8 können z.B. dünne Metallstreifen sein, welche mittels konventioneller Fertigungsmethoden (z. B. Löten oder Kleben an den Kontaktflächen 9) in die Nuten 7 der Substrate 1, 2 eingelötet werden. Die zweite Ausführungsform der Erfindung bietet neben der hermetischen Dichtigkeit der einzelnen Substrate weitere Vorteile wie z.B.
- elektrische Vortests mit den verschlossenen Substraten vor der elektrischen Verbindung der einzelnen Substrate mittels der Lotkugeln,
- Reparaturmöglichkeiten nach der Entlötung der Lotkugeln durch Austausch von einzelnen Substraten,
- einfache Modernisierung der einzelnen Substrate durch Ersatz dieser Substrate mit verbesserten integrierten Bauteilen, z.B. aufgrund neuer Technologien entstandener Schaltungen innerhalb der integrierten Bauteile,
- modulare Antennenstrukturen durch die Kombination von standardisierten und applikationsabhängigen Modulsubstraten.
- Modulare Modulstruktur, die durch Zusammenstellung geeigneter Modulsubstrate Sende-/Empfangsmodule, Sendemodule oder Empfangsmodule ermöglicht. Zudem kann das oberste Modulsubstrat mit integriertem Strahlerelement je nach Anwendung im Gesamtmodul integriert oder weggelassen werden.

## Patentansprüche

1. HF-Frontend in Mehrlagenstruktur umfassend elektronische Bauelemente (3, 4), wobei die Mehrlagenstruktur mehrere übereinander gestapelte, die Bauelemente (3, 4) tragende Substrate (1, 2) enthält,
**dadurch gekennzeichnet, dass**
in den Substraten (1, 2) Nuten (7) ausgeführt sind und zwischen den Substraten (1, 2) Dichtelemente (5, 8) zwecks hermetischer Abdichtung vorhanden sind, wobei die Dichtelemente (5, 8) in die Nuten (7) benachbarter Substrate (1, 2) eingreifen und dass benachbarte Substrate (1, 2) miteinander verlötet sind.

2. HF-Frontend nach Anspruch 1,
**dadurch gekennzeichnet, dass**
die Höhe (H) der Dichtelemente (5, 8) derart gewählt ist, dass zwischen den Substraten (1, 2) ein Spalt (S) entsteht, der zur Einbringung von Lötmittel ausgebildet ist.

3. HF-Frontend nach Anspruch 2,
**dadurch gekennzeichnet, dass**
in den Spalt (S) Lotkugeln (6) eingebracht sind.

4. HF-Frontend nach einem der vorangehenden Ansprüche,
**dadurch gekennzeichnet, dass**
die Nuten (7) In den Substraten (1, 2) umlaufend ausgeführt sind.

5. HF-Frontend nach einem der vorangehenden Ansprüche,
**dadurch gekennzeichnet, dass**
die Dichtelemente (5, 8) in die Nuten (7) eingelötet oder eingeklebt sind.

6. HF-Frontend nach einem der vorangehenden Ansprüche,
**dadurch gekennzeichnet, dass**
das Dichtelement (5) ein offenes Rahmenelement ist, welches in die Nuten (7) jeweils benachbarter Substraten (1, 2) eingreift, bzw. das Dichtelement (8) ein metallischer Deckel ist, der in die Nut (7) des jeweiligen Substrates (1 oder 2) eingreift.

7. HF-Frontend nach einem der vorangehenden Ansprüche 1-5,
**dadurch gekennzeichnet, dass**
das Dichtelemente (8) ein geschlossenes Deckenelement ist.

## Claims

1. HF front end in a multilayer structure comprising electronic components (3, 4), wherein the multilayer structure contains a plurality of substrates (1, 2) stacked one above the other and carrying the components (3, 4),
**characterized in that**
grooves (7) are formed in the substrates (1, 2) and sealing elements (5, 8) are provided between the substrates (1, 2) for the purpose of hermetic sealing, whereby the sealing elements (5,8) engage in the grooves (7) of adjacent substrates (1, 2) and **in that** adjacent substrates (1, 2) are soldered together.

2. HF front end according to Claim 1,
**characterized in that**
the height (H) of the sealing elements (5, 8) is selected so that there is a gap (S) between the substrates (1, 2), which is formed for the introduction of solder.

3. HF front end according to Claim 2,
**characterized in that**
solder balls (6) are introduced into the gap (S).

4. HF front end according to any one of the preceding claims,
**characterized in that**
the grooves (7) are formed circumferentially in the substrates (1, 2).

5. HF front end according to any one of the preceding claims,
**characterized in that**
the sealing elements (5, 8) are soldered or glued into the grooves (7).

6. HF front end according to any one of the preceding claims,
**characterized in that**
the sealing element (5) is an open frame element, which engages in the grooves (7) of each adjacent substrate (1, 2), or the sealing element (8) is a metallic cover, which engages in the groove (7) of the respective substrate (1 or 2).

7. HF front end according to any one of the preceding Claims 1-5,
**characterized in that**
the sealing element (8) is a closed cover element.

## Revendications

1. Module d'extrémité frontale HF de structure multicouche comprenant des composants électroniques (3, 4), la structure multicouche contenant plusieurs substrats (1, 2) empilés les uns sur les autres, portant les composants (3, 4),
**caractérisé en ce que**
des rainures (7) sont réalisées dans les substrats (1, 2) et des éléments d'étanchéité (5, 8) sont prévus entre les substrats (1, 2) pour réaliser une étanchéité hermétique, les éléments d'étanchéité (5, 8) s'engageant dans les rainures (7) de substrats adjacents (1, 2) et **en ce que** des substrats adjacents (1, 2) sont brasés les uns aux autres.

2. Module d'extrémité frontale HF selon la revendication 1,
**caractérisé en ce que**
la hauteur (H) des éléments d'étanchéité (5, 8) est choisie de telle sorte qu'une fente (S) soit obtenue entre les substrats (1, 2), laquelle est réalisée pour l'introduction de brasure.

3. Module d'extrémité frontale HF selon la revendication 2,
**caractérisé en ce que**
des billes de brasage (6) sont introduites dans la fente (S) .

4. Module d'extrémité frontale HF selon l'une quelconque des revendications précédentes,
**caractérisé en ce que**
les rainures (7) sont réalisées de manière circonférentielle dans les substrats (1, 2).

5. Module d'extrémité frontale HF selon l'une quelconque des revendications précédentes,
**caractérisé en ce que**
les éléments d'étanchéité (5, 8) sont brasés ou collés dans les rainures (7).

6. Module d'extrémité frontale HF selon l'une quelconque des revendications précédentes,
**caractérisé en ce que**
l'élément d'étanchéité (5) est un élément de cadre ouvert qui s'engage dans les rainures (7) de substrats adjacents respectifs (1, 2), ou l'élément d'étanchéité (8) est un couvercle métallique qui s'engage dans la rainure (7) du substrat respectif (1 ou 2).

7. Module d'extrémité frontale HF selon l'une quelconque des revendications 1 à 5,
**caractérisé en ce que**
l'élément d'étanchéité (8) est un élément de couvercle fermé.
